# EUROPÄISCHE PATENTSCHRIFT

(11) **EP 1 875 484 B1**
(45) Veröffentlichungstag und Bekanntmachung des Hinweises auf die Patenterteilung: **25.05.2011**
(21) Anmeldenummer: 06724437.6
(22) Anmeldetag: 20.04.2006
(51) Int. Cl.: H01J 37/34

(54) **MAGNETSYSTEM FÜR EINE ZERSTÄUBUNGSKATHODE**
MAGNET SYSTEM FOR A SPUTTERING CATHODE
SYSTEME MAGNETIQUE POUR CATHODE DE PULVERISATION

(30) Priorität: 25.04.2005 DE 102005019100
(43) Veröffentlichungstag der Anmeldung: 09.01.2008
(73) Patentinhaber: Singulus Technologies AG, 63796 Kahl am Main (DE)
(72) Erfinder: WEINDEL, Christian, 75433 Maulbronn (DE); LUKHAUB, Waldemar, 71665 Vaihingen (DE); PACEARESCU, Larisa, 75447 Sternenfels (DE); RUDAKOWSKI, Siegmar, 40885 Ratingen (DE)
(74) Vertreter: Vossius & Partner
(86) Internationale Anmeldenummer: PCT/EP2006/003594
(87) Internationale Veröffentlichungsnummer: WO 2006/114229

(56) Entgegenhaltungen:
- US-A- 4 746 417
- US-A- 5 194 131
- US-A- 5 374 343
- US-A1- 2001 022 271
- US-A1- 2003 136 671
- US-B1- 6 258 217
- PATENT ABSTRACTS OF JAPAN Bd. 010, Nr. 094 (C-338), 11. April 1986 (1986-04-11) & JP 60 224775 A (FUJITSU KK), 9. November 1985 (1985-11-09)

## Beschreibung

Die vorliegende Erfindung bezieht sich auf ein Magnetsystem für eine Zerstäubungskathode mit einer ferromagnetischen Jochplatte und wenigstens einer ersten und einer zweiten Gruppe von Magneten, die mit entgegengesetzter Polung auf der Jochplatte angeordnet sind, wobei die Magneten der ersten Gruppe eine im Wesentlichen geschlossene innenliegende Magnetreihe bilden, und die Magnete der zweiten Gruppe eine im Wesentlichen geschlossene außenliegende Magnetreihe bilden, die die innenliegende Magnetreihe radial umgibt.

Zerstäubungskathoden werden in unterschiedlichen Gebieten eingesetzt, um Objekte zu beschichten. Dabei ist es beispielsweise für die Herstellung optischer Speichermedien wichtig, dass die durch Zerstäubung bzw. Sputtern aufgebrachten Schichten keine große Variation hinsichtlich der Dicke aufweisen, da dies die Qualität der optischen Speichermedien wesentlich beeinträchtigen kann. Darüber hinaus besteht das Bedürfnis, dass die in den Zerstäubungskathoden verwendeten Targets möglichst viele Substrate beschichten, da die Targets mit hohen Kosten verbunden sind.

In der Vergangenheit wurden zur Optimierung von Sputterprozessen hinsichtlich einer Gleichmäßigkeit der aufgebrachten Schichtdicke, sowie einer Optimierung der Beschichtungen mit einem Target, unterschiedlichste Magnetsysteme entwickelt. Beispielsweise sind Magnetsysteme bekannt, bei denen Magnete wenigstens teilweise hinter einem zu zerstäubenden Target liegen, und ferner Magnete aufweisen, die das Target radial umgeben. Auch in unterschiedlichen Ebenen hinter einem zu zerstäubenden Target liegende Magnetsysteme sind bekannt.

Das Dokument JP60224775 offenbart ein Magnetsystem mit zwei konzentrisch angeordneten Ringen entgegengesetzter Polung hinter einem Target. Beide Ringe weisen dabei zur gleichen Seite hin eine dreiecksförmige Einkerbung oder eine Abflachung auf. Das Magnetsystem ist dabei an die Substratform angepasst um die Haftfähigkeit des Targetmaterials auf dem Substrat zu erhöhen.

Solche bekannten Magnetsysteme besitzen jedoch einen sehr komplizierten Aufbau des Magnetsystems und sind relativ groß, da Magnete und/oder Magnetpole in unterschiedlichen Ebenen vorgesehen sind.

Ausgehend von solchen Magnetsystemen liegt der vorliegenden Erfindung daher die Aufgabe zugrunde, ein Magnetsystem für eine Zerstäubungskathode der oben genannten Art vorzusehen, das bei einem einfachen Aufbau eine gute Gleichmäßigkeit der Schichtdicke sowie eine hohe Anzahl von Beschichtungsvorgängen pro Target ermöglicht.

Erfindungsgemäß wird diese Aufgabe bei einem Magnetsystem der oben genannten Art dadurch gelöst, dass die innenliegende Magnetreihe einen ersten Kreisbogen bildet, der einen Winkel von größer 180° eines ersten Kreises beschreibt, sowie einen zweiten Kreisbogen eines zweiten Kreises, wobei der zweite Kreisbogen innerhalb des ersten Kreises liegt, und wobei die außenliegende Magnetreihe einen dritten Kreisbogen bildet, der einen Winkel von größer 180° eines dritten Kreises beschreibt, sowie einen vierten Kreisbogen eines vierten Kreises, wobei der vierte Kreisbogen innerhalb des dritten Kreises liegt, und wobei der dritte Kreis den ersten Kreis umgibt.

Das oben beschriebene Magnetsystem besitzt einen einfachen Aufbau und ermöglicht, insbesondere bei einem Einsatz in einer Zerstäubungskathode mit rotierendem Magnetsystem, eine gleichmäßige Beschichtung der zu beschichtenden Substrate sowie eine hohe Targetausbeute, d.h. eine hohe Anzahl von Beschichtungsvorgängen pro Target.

Gemäß einer bevorzugten Ausführungsform der Erfindung weisen die ersten und dritten Kreise einen gemeinsamen Mittelpunkt auf, so dass die ersten und dritten Kreisbögen koaxial zueinander sind.

Die unterschiedlichen Kreisbögen beschreiben unterschiedliche Winkel, wobei der erste Kreisbogen vorzugsweise einen Winkel zwischen 220° und 250° und insbesondere von 235° beschreibt, der zweite Kreisbogen vorzugsweise einem Winkel zwischen 90° und 120° und insbesondere von ungefähr 103° beschreibt, der dritte Kreisbogen vorzugsweise einen Winkel zwischen 225° und 255° und insbesondere von ungefähr 239° beschreibt und der vierte Kreisbogen vorzugsweise einen Winkel zwischen 95° und 125° und insbesondere von ungefähr 111° beschreibt.

Gemäß einer Ausführungsform der Erfindung besitzen die ersten und zweiten Kreise der innenliegenden Magnetreihe im Wesentlichen den gleichen Radius, während der Radius des dritten Kreises vorzugsweise größer ist als der Radius des vierten Kreises, und zwar vorzugsweise um 80% bis 100% insbesondere um ungefähr 90%.

Vorteilhafterweise besitzt die außenliegende Magnetreihe zwei gerade Segmente, die die freien Enden der dritten und vierten Kreisbögen verbindet, um die geschlossene außenliegende Magnetreihe zu bilden. Diese dienen zu einer Optimierung des durch die Magnetreihen erzeugten Magnetfeldes.

Bei einer besonders bevorzugten Ausführungsform der Erfindung ist ferner eine dritte Gruppe von Magneten vorgesehen, die auf der Jochplatte angeordnet ist und eine dem vierten Kreisbogen gegenüberliegende, nicht geschlossene Magnetreihe bildet, die außerhalb der ersten und zweiten Magnetreihen liegt. Die Magneten der dritten Gruppe sind vorzugsweise in der gleichen Richtung gepolt wie die Magneten der zweiten Gruppe, um zu verhindern, dass dazwischen ein Magnetfeldtunnel gebildet wird. Vorzugsweise beschreiben die Magneten der dritten Gruppe einen fünften Kreisbogen eines fünften Kreises mit einem Winkel von 15° bis 45° und insbesondere von 32°. Dabei besitzt der fünfte Kreis vorzugsweise einen größeren Radius als der dritte Kreis und alle der vorgenannten Magneten liegen innerhalb des fünften Kreises. Die Magneten der dritten Gruppe liegen ferner vorzugsweise innerhalb des vierten Kreises.

Zur Erzeugung einer Symmetrie liegen die Mittelpunkte der zuvor genannten Kreise vorzugsweise auf einer gemeinsamen Geraden, und die Magnetreihen sind vorzugsweise bezüglich der Geraden spiegelsymmetrisch angeordnet. Ferner ist die Jochplatte vorzugsweise eben und um einen Mittelpunkt derselben rotationssymmetrisch ausgebildet. Vorzugsweise liegt der Mittelpunkt der Jochplatte auf der Geraden, auf der auch die Mittelpunkte der Kreise liegen. Die Mittelpunkte der Kreise sind bezüglich des Mittelpunkts der Jochplatte vorzugsweise versetzt, wobei die Mittelpunkte der Kreise mit unterschiedlichem Abstand bezüglich des Mittelpunkts der Jochplatte versetzt sind. Dabei ist der gemeinsame Mittelpunkt des ersten und dritten Kreises entlang der Geraden auf einer Seite des Mittelpunktes der Jochplatte angeordnet, während die Mittelpunkte des zweiten und vierten Kreises entlang der Geraden auf der anderen Seite des Mittelpunktes der Jochplatte angeordnet sind. Ferner liegt der gemeinsame Mittelpunkt des ersten und dritten Kreises vorzugsweise am nächsten zum Mittelpunkt der Jochplatte, während der Mittelpunkt des zweiten Kreises weiter vom Mittelpunkt der Jochplatte entfernt liegt und der Mittelpunkt des vierten Kreises noch weiter vom Mittelpunkt der Jochplatte entfernt liegt.

Um eine genaue und fixierte Anordnung der Magneten auf der Jochplatte zu erreichen, sind diese vorzugsweise durch wenigstens eine nicht-magnetische Platte mit den entsprechenden Durchführöffnungen für die Magneten geführt. Ferner sind an der Jochplatte vorzugsweise unmagnetische Ausgleichsgewichte vorgesehen, um zu erreichen, dass der Schwerpunkt des Magnetsystems auf einer sich durch einen Mittelpunkt der Jochplatte erstreckenden Normalen liegt, die als Drehachse des Magnetsystems dient. Durch die Ausgleichsgewichte wird eine Unwucht des Magnetsystems verhindert.

Die der Erfindung zugrunde liegende Aufgabe wird auch bei einer Zerstäubungskathode gelöst, die ein Target mit einer vorderen Zerstäubungsfläche, ein hinter dem Target liegendes Magnetsystem der oben beschriebenen Art und eine Vorrichtung zum Drehen des Magnetsystems um eine zur Jochplatte senkrecht stehende Drehachse aufweist. Eine solche Zerstäubungskathode weist vorzugsweise eine Steuervorrichtung zum Steuern der Drehgeschwindigkeit des Magnetsystems in Abhängigkeit von einem Zerstäubungszustand des Targets auf, um einerseits eine auf einem Gegenstand aufzubringende Beschichtung zu homogenisieren und andererseits die Targetlebenszeit zu verlängern.

Die der Erfindung zugrunde liegende Aufgabe wird auch bei einem Verfahren zum Beschichten eines Substrats durch einen Magnetronzerstäubungsprozess gelöst, bei dem ein Target mit einer vorderen Zerstäubungsfläche zerstäubt wird, während ein hinter dem Target liegendes Magnetsystem der oben beschriebenen Art gedreht wird. Die Verwendung eines rotierenden Magnetsystems der oben beschriebenen Art ermöglicht bei einem einfachen Aufbau des Magnetsystems eine homogene Beschichtung eines zu beschichtenden Gegenstands.

Bei dem Verfahren wird vorzugsweise der Zerstäubungszustand des Targets bestimmt und die Drehgeschwindigkeit des Magnetsystems in Abhängigkeit vom Zerstäubungszustand des Targets gesteuert.

Die Erfindung wird nachfolgend anhand eines bevorzugten Ausführungsbeispiels unter Bezugnahme auf die Zeichnungen näher erläutert; in den Zeichnungen zeigt:
- Fig.1: eine schematische Schnittansicht durch eine Zerstäubungskathode mit einem Magnetsystem gemäß der vorliegenden Erfindung;
- Fig. 2: eine schematische Draufsicht auf ein Magnetsystem gemäß der vor- liegenden Erfindung;
- Fig. 3: eine perspektivische auseinandergezogene Ansicht eines Magnetsys- tems gemäß der vorliegenden Erfindung; und
- Fig. 4.: eine Tabelle, die unterschiedliche Drehgeschwindigkeiten eines Mag- netsystems in Abhängigkeit von einer verbleibenden Targetlebenszeit zeigt.

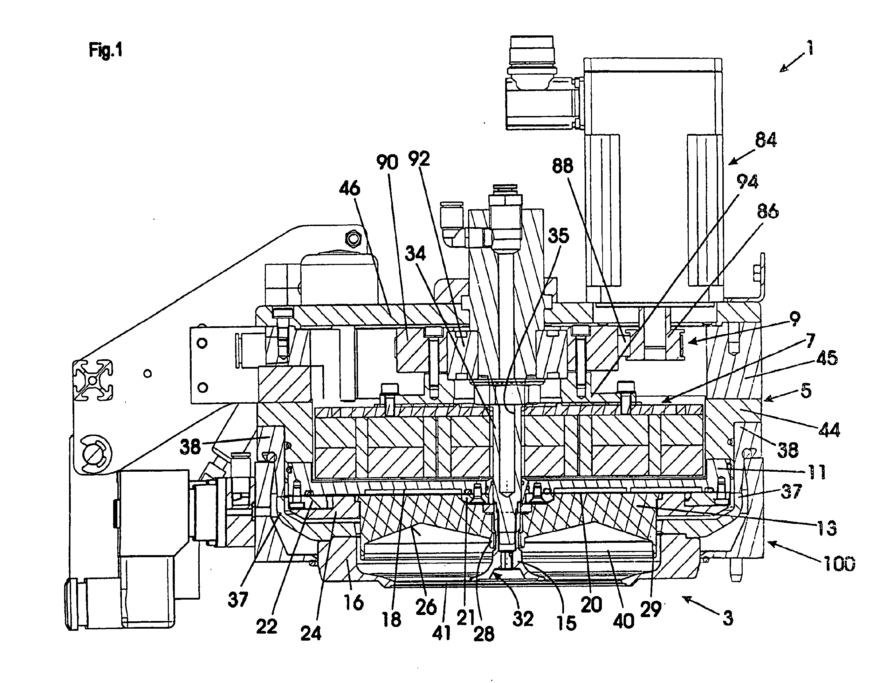

Fig. 1 zeigt eine Zerstäubungskathode 1, wie sie beispielsweise für die Beschichtung optischer Speichermedien eingesetzt wird.

Die Zerstäubungskathode 1 besitzt einen Zerstäubungsabschnitt 3, ein Gehäuse 5, ein in dem Gehäuse 5 aufgenommenes Magnetsystem 7 und eine Antriebsanordnung 9 für das Magnetsystem 7.

Der Zerstäubungsabschnitt 3 wird im Wesentlichen gebildet durch eine Kathodenplatte 11, die auch Teil des Gehäuses 5 ist, ein Target 13, sowie eine Innenmaske 15 und eine Außenmaske 16. Die Kathodenplatte 11, die beispielsweise aus Kupfer oder einer Kupferlegierung besteht, besitzt an ihrer nach unten weisenden Seite einen Kühlkanal 18, der mit einer nicht näher dargestellten Kühlmittelversorgung in Verbindung steht, um die Kathodenplatte bzw. das damit in Verbindung stehende Target 13 zu kühlen. Der Kühlkanal 18 ist durch eine, eine Mittelöffnung aufweisende Membran 20 abgedeckt, die über entsprechende Halteringe 21, 22 am Innenumfang bzw. am Außenumfang der Membran 20 an die Kathodenplatte 11 geklemmt ist. Um den Kühlkanal 18 abzudichten, sind zwischen der Membran 20 und der Kathodenplatte 11 im Bereich der Halteringe 21, 22 entsprechende Dichtelemente wie beispielsweise O-Ringe vorgesehen. Die Halteringe 21, 22 sind über Schrauben oder sonstige Befestigungselemente an der Kathodenplatte 11 befestigt.

Das Target 13 ist ebenfalls an der Kathodenplatte 11 befestigt und steht über die Membran 20 in elektrisch leitendem Kontakt hiermit. Das Target wird über einen Targethaltering 24 lösbar an der Kathodenplatte 11 gehalten. Der Targethaltering 24 steht mit dem äußeren Haltering 22 für die Membran 20 in Eingriff und stellt hierüber die Verbindung zur Kathodenplatte 11 her. Beispielsweise steht der Targethaltering 24 mit dem Haltering 22 in Schraubkontakt. Die Membran 20, die Halteringe 21, 22 sowie der Targethaltering 24 sind jeweils aus einem elektrisch leitenden Material hergestellt, und stellen eine elektrische Verbindung zwischen der Kathodenplatte 11 und dem Target 13 sicher.

Das Target 13 besitzt eine kreiszylindrische Form mit einer im Wesentlichen ebenen Rückseite, in der eine Ausnehmung zur Aufnahme des Halterings 21 vorgesehen ist. Ferner besitzt das Target 13 eine Mittelöffnung zur Durchführung der Innenmaske 15, wie nachfolgend noch näher erläutert wird.

Das Target 13 besitzt eine ringförmige Zerstäubungsoberfläche 26, die durch zwei zur Rückseite geneigte, sich schneidende Geraden gebildet wird. Der Innenumfang der Zerstäubungsoberfläche 26 wird durch einen ringförmigen Vorsprung 28 begrenzt, während der Außenumfang der ringförmigen Zerstäubungsoberfläche 26 durch einen ringförmigen Vorsprung 29 begrenzt wird.

Wie zuvor angedeutet, erstreckt sich die Innenmaske 15 durch eine Mittelöffnung des Targets 13 hindurch. Vor dem Target besitzt die Innenmaske 15 einen sich erweiternden Kopfteil 32, der dazu dient, einen Mittelbereich eines zu beschichtenden Gegenstands gegenüber der Zerstäubungsoberfläche 26 abzuschirmen. Die Innenmaske 15 ist gegenüber der Kathodenplatte 11 und dem Target 13 elektrisch isoliert, und wird durch einen sogenannten Kühlfinger 34 getragen. Der Kühlfinger 34 erstreckt sich in die Mittelöffnung des Targets 13, durch die Kathodenplatte 11, das Magnetsystem 7 und ist am Gehäuse 5 befestigt. Zwischen dem Kühlfinger 34 und der Kathodenplatte 11 ist ein Isolierelement vorgesehen, um den Kühlfinger 34 gegenüber der Kathodenplatte 11 elektrisch zu isolieren.

Der Kühlfinger 34 weist eine Sackbohrung 35 auf, in die in geeigneter Weise eine Kühlflüssigkeit ein- und auch wieder ausgeleitet wird, um die Innenmaske 15 zu kühlen.

Hierzu sind entsprechende Anschlusselemente an dem Kühlfinger 34 vorgesehen.

Die Außenmaske 16 steht über entsprechende Halteringe 37, 38 mit dem Gehäuse 5 in Kontakt und wird hierdurch gegen eine Deckelplatte einer Sputterkammer gedrückt. Die Außenmaske 16 sowie die sie tragenden Elemente sind gegenüber der Kathodenplatte 11 elektrisch isoliert. Das Target 13, die Maske 15 und die Außenmaske 16 definieren einen Zerstäubungsraum 40 mit einer ringförmigen Öffnung 41, die während eines Beschichtungsvorgangs durch ein zu beschichtendes Substrat im Wesentlichen geschlossen wird.

Das Gehäuse 5 der Zerstäubungskathode 1 besteht, wie schon erwähnt, unter anderem aus der Kathodenplatte 11. An die Kathodenplatte 11 schließt sich ein elektrisch isolierendes ringförmiges Gehäusebauteil 44 an. An das ringförmige, isolierende Gehäusebauteil 44 schließt sich ein weiteres ringförmiges Gehäusebauteil 45 an, das wiederum mit einer Rückplatte 46 des Gehäuses 5 verbunden ist. Die Kathodenplatte 11, die Gehäusebauteile 44, 45 sowie die Rückplatte 46 bilden zusammen ein im Wesentlichen geschlossenes Gehäuse zur Aufnahme und zum Halten des Magnetsystems 7, des Kühlfingers 34 für die Innenmaske 15, und der Antriebsanordnung 9 für das Magnetsystem, wie nachfolgend noch näher erläutert wird.

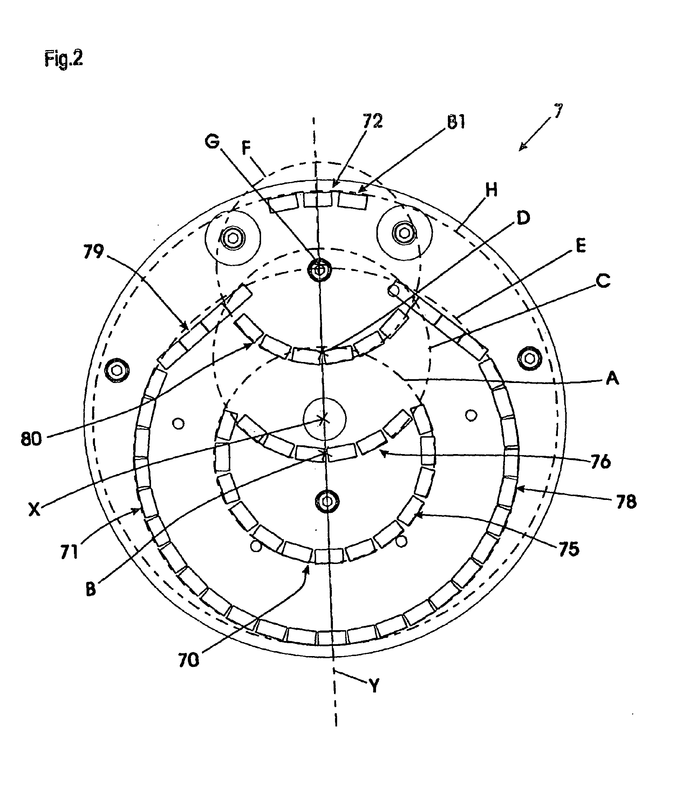

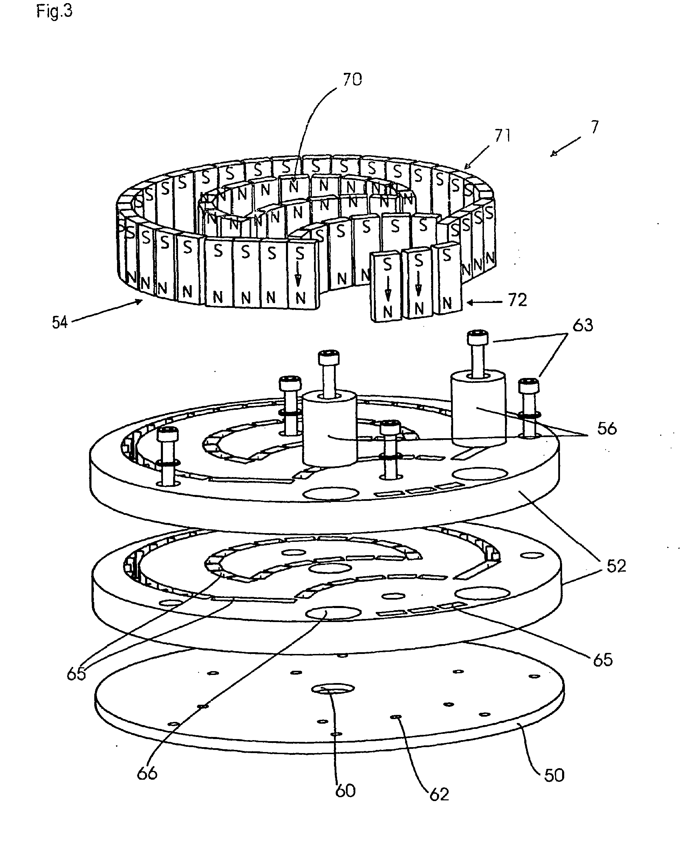

Das Magnetsystem 7 wird nachfolgend unter Bezugnahme auf die Figuren, insbesondere die Figuren 2 und 3 näher erläutert. Dabei zeigt Fig. 2 eine Draufsicht auf das Magnetsystem 7 und Fig. 3 eine perspektivische, auseinandergezogene Ansicht des Magnetsystems 7.

Das Magnetsystem 7 besteht, wie am Besten in Fig. 3 zu erkennen ist, aus einer Jochplatte 50, zwei Führungsplatten 52, einer Vielzahl von quaderförmigen Magneten 54, sowie Ausgleichsgewichten 56.

Die Jochplatte 50 besteht aus einem magnetisch leitenden Material und besitzt die Form einer flachen, runden Scheibe mit einer kreisförmigen Mittelöffnung 60. Die Mittelöffnung 60 ist derart bemessen, dass sie eine kontaktfreie Durchführung des Kühlfingers 34 für die Mittelmaske 15 ermöglicht.

Die Jochplatte 50 weist ferner eine Vielzahl von Bohrungen 62 zur Aufnahme von Befestigungselementen, wie beispielsweise Schrauben 63 auf, die beispielsweise zur Befestigung der Führungsplatten 52 bzw. der Ausgleichsgewichte 56 dienen.

Die Führungsplatten 52 sind jeweils aus einem unmagnetischen nicht leitenden Material, wie beispielsweise Kunststoff. Die Führungsplatten 52 besitzen im Wesentlichen dieselbe Form und dienen vorwiegend zur formschlüssigen Aufnahme der Magnete 54. Zu diesem Zweck weisen die Führungsplatten 52 entsprechende Durchgangsöffnungen 65 zur Aufnahme der Magnete 54 auf. Die Durchgangsöffnungen 65 erstrecken sich jeweils senkrecht zu einer Ebene der Führungsplatten 52. Die Anordnung der Durchgangsöffnungen 65 bestimmt die Anordnung der Magneten 54, die nachfolgend noch näher beschrieben wird.

Die Führungsplatten 52 weisen ferner Durchgangsöffnungen 66 zur Aufnahme der Ausgleichsgewichte 56 auf, und sind über entsprechende Befestigungselemente, wie beispielsweise Schrauben 63, an der Jochplatte 50 befestigt.

Im Nachfolgenden wird die Anordnung der Vielzahl von Magneten 54 näher erläutert.

Die Magnete 54 sind in drei Gruppen unterteilt; eine erste Gruppe 70, eine zweite Gruppe 71 und eine dritte Gruppe 72. Die Magnete der ersten Gruppe 70 sind mit entgegengesetzter Polung zu den Magneten der zweiten Gruppe 71 auf der Jochplatte 50 angeordnet, wie in Fig. 3 zu erkennen ist. Die Magnete der zweiten Gruppe sind mit der gleichen Polung auf der Jochplatte 50 angeordnet, wie die Magneten der dritten Gruppe 72, wie ebenfalls in Fig. 3 zu erkennen ist.

Wie in der Draufsicht gemäß Fig. 2 zu erkennen ist, bilden die Magnete der ersten Gruppe 70 eine im Wesentlichen geschlossene innenliegende Magnetreihe, während die Magnete der zweiten Gruppe 71 eine im Wesentlichen geschlossene außenliegende Magnetreihe bilden. Die Magnete der dritten Gruppe 72 bilden hingegen keine geschlossene Magnetreihe und liegen außerhalb der ersten und zweiten geschlossenen Magnetreihe.

Ein Teil der Magnete der ersten Gruppe 70 beschreibt einen ersten Kreisbogen 75 eines ersten Kreises A. Dabei liegen die den Kreisbogen 75 beschreibenden Magnete mit ihrer Außenseite an dem Kreis A an. Der Kreisbogen 75 besitzt einen Winkel von größer 180°, und insbesondere einen Winkel zwischen 220° und 250°, vorzugsweise von ungefähr 235°. Ein Mittelpunkt B des Kreises A ist bezüglich eines Mittelpunktes X der Jochplatte 50 entlang einer Geraden Y versetzt. Wie nachfolgend noch näher beschrieben wird, ist das Magnetsystem 7 bezüglich der Geraden Y spiegelsymmetrisch.

Ein zweiter Teil der ersten Gruppe 70 von Magneten bildet einen zweiten Kreisbogen 76 eines zweiten Kreises C. Der zweite Kreisbogen 76 beschreibt einen Winkel zwischen 90° und 120° und vorzugsweise von ungefähr 103°. Der zweite Kreisbogen 76 liegt innerhalb des Kreises A und verbindet die freien Enden des ersten Kreisbogens 75, um eine geschlossene Magnetreihe zu bilden. Dabei besitzt die geschlossene Magnetreihe eine Mondform.

Ein Mittelpunkt D des Kreises C liegt ebenfalls auf der Geraden Y und zwar versetzt zum Mittelpunkt X der Jochplatte 50. Die Mittelpunkte der ersten und zweiten Kreise A, C liegen entlang der Linie Y auf entgegengesetzten Seiten des Mittelpunktes X der Jochplatte 50.

Ein Teil der Magnete der zweiten Gruppe 71 der Vielzahl von Magneten 54 bildet einen dritten Kreisbogen 78 eines dritten Kreises E. Der Mittelpunkt des Kreises E fällt mit dem Mittelpunkt B des ersten Kreises A zusammen, so dass die ersten und dritten Kreisbögen 75, 78 koaxial zueinander sind.

Der dritte Kreisbogen 78 beschreibt wiederum einen Winkel von größer 180°. Dabei beschreibt der dritte Kreisbogen einen Winkel zwischen 225° und 255° und vorzugsweise von ungefähr 239°.

Ein Teil der zweiten Gruppe 71 der Vielzahl von Magneten 54 bildet zwei gerade Abschnitte 79 der geschlossenen Magnetreihe. Die geraden Abschnitte 79 erstrecken sich im Wesentlichen von den freien Enden des dritten Kreisbogens 78 aus und sind zur Geraden Y hin geneigt. Die geraden Abschnitte 79 liegen im Wesentlichen im Inneren des Kreises E und bilden eine Kreissehne desselben. Die beiden geraden Abschnitte 79 sind ungefähr mit einem Winkel von 100° zueinander angeordnet.

Ein weiterer Teil der Magneten der zweiten Gruppe 71 der Vielzahl von Magneten 54 bildet einen vierten Kreisbogen 80 eines vierten Kreises F. Ein Mittelpunkt G des Kreises F liegt wiederum auf der Geraden Y und ist bezüglich des Mittelpunkts X der Jochplatte 50 versetzt. Der Mittelpunkt G des Kreises F und der Mittepunkt B des Kreises E liegen entlang der Linie Y auf entgegengesetzten Seiten des Mittelpunkts X der Jochplatte 50. Der Mittelpunkt G des Kreises F ist weiter vom Mittelpunkt X der Jochplatte 50 entfernt als der Mittelpunkt D des Kreises C. Der Mittelpunkt B der Kreise A und E befindet sich wiederum näher an dem Mittelpunkt X der Jochplatte 50 als der Mittelpunkt D.

Der Kreisbogen 80 verbindet im Wesentlichen die freien Enden der geraden Abschnitte 79. Somit bilden die Magnete, die den dritten Kreisbogen 78, die geraden Abschnitte 79 und den vierten Kreisbogen 80 bilden, eine im Wesentlichen geschlossene äußere Magnetreihe.

Der vierte Kreisbogen 80 beschreibt einen Winkel zwischen 90° und 125° und vorzugsweise von ungefähr 111°.

Der Radius des dritten Kreises E ist wesentliche größer als der Radius des vierten Kreises F. Vorzugsweise ist der Radius des dritten Kreises E um 80 bis 100 %, vorzugsweise um ungefähr 90 % größer als der Radius des vierten Kreises F. Ferner ist der Radius des dritten Kreises E auch größer als der jeweilige Radius des Kreises A bzw. des Kreises C. Die Radien der Kreise A und C sind im Wesentlichen gleich.

Die Magnete der dritten Gruppe 72 der Vielzahl von Magneten 54 bilden, wie erwähnt, eine nicht geschlossene Magnetreihe und beschreiben einen fünften Kreisbogen 81 eines fünften Kreises H, dessen Mittelpunkt mit dem Mittelpunkt X der Jochplatte 50 zusammenfällt. Der Kreis H besitzt den größten Radius und die Magnete der ersten und zweiten Gruppe liegen innerhalb des Kreises H. Der fünfte Kreisbogen beschreibt einen Winkel von 15° bis 45° und vorzugsweise von ungefähr 32°. Die Führungsplatten 52 weisen entsprechende Durchgangsöffnungen 65 auf, um die Magneten 54 in der oben genannten Art und Weise anzuordnen.

Die Ausgleichsgewichte 56 bestehen aus einem nicht magnetischen Material und liegen im Wesentlichen innerhalb des Kreises H. Sie dienen dazu, sicherzustellen, dass ein Schwerpunkt des Magnetsystems 7, bestehend aus Jochplatte 50, Führungsplatten 52, Magneten 54 und Ausgleichsgewichten 56 entlang einer sich senkrecht zu einer Ebene der Jochplatte 50 und durch den Mittelpunkt X erstreckenden Achse liegt. Diese Achse ist, wie nachfolgend noch näher beschrieben wird, eine Drehachse des Magnetsystems 7. Die Ausgleichsgewichte 56 sind über entsprechende Befestigungselemente, wie beispielsweise Schrauben 63 an der Jochplatte 50 befestigt.

Bei der oben dargestellten Anordnung der Magneten 54 wird zwischen der ersten Gruppe 70 und der zweiten Gruppe 71 von Magneten ein Magnetfeldtunnel gebildet, der sich durch das Target 13 hindurch erstreckt. Dieser Magnetfeldtunnel besitzt einen Scheitelpunkt, der im Wesentlichen auf einer zwischen der ersten Gruppe 70 und der zweiten Gruppe 71 von Magneten liegenden Linie liegt, und somit bezüglich der Mitte der Jochplatte asymmetrisch ist.

Die dritte Gruppe von Magneten 72 besitzt den Zweck zu verhindern, dass sich ein zusätzlicher Magnettunnel bildet, der sich ausgehend von den Magneten des Kreisbogens 80 nach außen erstreckt. Dadurch, dass die Magnete der zweiten Gruppe 71 und der dritten Gruppe 72 in gleicher Richtung gepolt sind, wirken hier abstoßende Magnetkräfte, die die Bildung eines Magnetfeldtunnels unterdrücken.

Nachfolgend wird die Antriebsanordnung 9 der Zerstäubungskathode 1 näher erläutert. Die Antriebsanordnung 9 weist einen Antriebsmotor 84 auf, der an der Rückplatte 46 des Gehäuses 5 angebracht ist, und zwar im Wesentlichen außerhalb des Gehäuses 5. Eine Drehwelle 86 des Antriebsmotors 84 erstreckt sich durch eine entsprechende Öffnung in der Rückplatte 46 des Gehäuses 5 in das Gehäuse 5 hinein. Ein freies Ende der Drehwelle 86 steht über einen Keilriemen 88 mit einem Ringelement 90 in Verbindung, um eine Drehbewegung der Drehwelle 86 auf das Ringelement 90 zu übertragen. Das Ringelement 90 ist über eine entsprechende Lageranordnung 92 an den Kühlfinger 34 getragen. Dabei ist das Ringelement derart an dem Kühlfinger 34 getragen, dass es in Längsrichtung des Kühlfingers 34 nicht bewegbar ist, sich jedoch um den Kühlfinger 34 herum drehen kann. Das Ringelement 90 ist somit örtlich stationär, aber drehbar innerhalb des Gehäuses 5 getragen.

Das Ringelement 90 ist mit einem Tragflansch 94 für die Jochplatte 50 verbunden, und zwar über entsprechende Befestigungselemente, wie beispielsweise Schrauben. Der Tragflansch 94 steht darüber hinaus auch mit der Lageranordnung 92 in Verbindung und ist durch diese geführt.

Der Tragflansch 94 ist wiederum über entsprechende Befestigungselemente, wie beispielsweise Schrauben mit einer von den Magneten 54 abgewandten Seite der Jochplatte 50 verbunden, wie in Fig. 1 zu erkennen ist.

Nachfolgend wird der Betrieb der Zerstäubungskathode 1 anhand der Figuren näher erläutert.

Die Zerstäubungskathode 1 sitzt auf einem Gehäuse einer Vakuumkammer auf, das bei 100 angedeutet ist, und erstreckt sich teilweise in das Vakuumgehäuse hinein. Über eine nicht näher dargestellte Handhabungsvorrichtung wird ein zu beschichtendes Substrat, wie beispielsweise ein Substrat eines optischen Datenträgers in den Bereich der ringförmigen Öffnung 41 des Zerstäubungsraums 40 gebracht, und in Kontakt mit der Innen- und Außenmaske 15 bzw. 16 gebracht, um den Zerstäubungsraum 40 im Wesentlichen abzuschließen.

Anschließend wird eine negative Spannung von ungefähr -800 Volt an die Kathodenplatte 11 und somit das Target 13 angelegt. Die Innen- und Außenmaske sind in geeigneter Weise geerdet und wirken daher als Anode.

Über nicht näher dargestellte Zuleitungen wird Argongas in den Prozessraum 40 eingeführt, wo es in bekannter Weise ionisiert und in Richtung der Zerstäubungsoberfläche 26 des Targets 13 beschleunigt wird. Die Argonionen werden durch den sich durch das Target 13 hindurch erstreckenden Magnetfeldtunnel konzentriert, wodurch die Zerstäubung der Zerstäubungsoberfläche 26 gesteuert werden kann. Durch eine derartige Steuerung der Zerstäubung lässt sich andererseits die durch Zerstäubung aufgebrachte Schichtdicke steuern, als auch eine bestimmte Abnutzung des Targets 13 erreichen, so dass dieses für möglichst viele Zerstäubungsvorgänge eingesetzt werden kann. Während des Zerstäubungsvorgangs wird das Magnetsystem 7 um eine Drehachse gedreht, so dass der bezüglich der Drehachse asymmetrische Magnetfeldtunnel über das Target 13 streicht.

Bei der Drehung des Magnetsystems 7 werden durch den sich bewegenden Magnetfeldtunnel in dem Target 13 und sonstigen elektrisch leitenden Teilen Wirbelströme erzeugt, die wiederum das Magnetfeld verändern. Dabei ist diese Veränderung des Magnetfelds abhängig von der Abnutzungsrate des Targets 13. Um jedoch über eine Vielzahl von Beschichtungsvorgängen hinweg im Wesentlichen gleiche Bedingungen hinsichtlich des Magnetfelds zu erreichen, wird die Drehgeschwindigkeit des Magnetsystems 7 in Abhängigkeit von einer Abnutzungsrate des Targets 13 gesteuert. Insbesondere wird mit zunehmendem Targetalter (d.h. steigende Anzahl von Sputtervorgängen) die Drehzahl für das Magnetsystem reduziert.

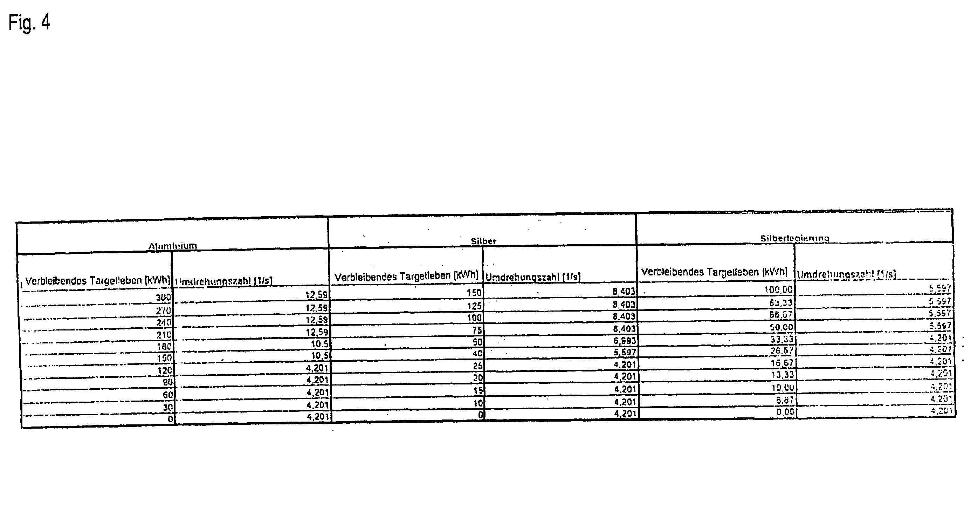

Fig. 4 zeigt in Tabellenform unterschiedliche Umdrehungszahlen in Abhängigkeit von einer verbleibenden Targetlebenszeit, die in Kilowatt-Stunden ausgedrückt ist. Dabei zeigt die Tabelle unterschiedliche Umdrehungszahlen für Targets aus Aluminium, Silber und einer Silberlegierung.

Wie deutlich zu erkennen ist, kann die Drehzahl während eines ersten Teilbereichs der Targetlebenszeit zunächst konstant gehalten werden, wobei sie anschließend reduziert wird.

Bei Aluminium wird die Drehzahl beispielsweise gegen Ende der verbleibenden Lebenszeit auf ungefähr 1/3 der ursprünglichen Drehzahl reduziert. Bei einem Silbertarget wird die Drehzahl auf ungefähr die Hälfte der ursprünglichen Drehzahl reduziert und bei einer Silberlegierung auf ca. 3/4 der ursprünglichen Drehzahl.

Welche Drehzahlwerte bei welcher verbleibenden Targetlebenszeit vorteilhaft sind, kann empirisch ermittelt werden und in einer entsprechenden Nachschautabelle, die für jedes Targetmaterial gespeichert werden kann, hinterlegt werden.

Die Steuervorrichtung für den Antriebsmotor kann auf die Nachschautabelle zugreifen und die Drehzahl entsprechend steuern.

Die Erfindung wurde zuvor anhand eines bevorzugten Ausführungsbeispiels der Erfindung beschrieben, ohne auf das konkret dargestellte Ausführungsbeispiel beschränkt zu sein.

## Patentansprüche

1. Magnetsystem (7) für eine Zerstäubungskathode (1), mit einer Jochplatte (50) und wenigstens einer ersten (70) und einer zweiten Gruppe (71) von Magneten, die mit entgegengesetzter Polung auf der Jochplatte (50) angeordnet sind, wobei die Magnete der ersten Gruppe (70) eine im Wesentlichen geschlossene innenliegende Magnetreihe bilden und die Magnete der zweiten Gruppe (71) eine im Wesentlichen geschlossene außenliegende Magnetreihe bilden, die die innenliegende Magnetreihe radial umgibt, wobei die innenliegende Magnetreihe einen ersten Kreisbogen (75) bildet, der einen Winkel von größer 180° eines ersten Kreises (A) beschreibt, und die außenliegende Magnetrei he einen dritten Kreisbogen (78) bildet, der einen Winkel von größer 180° eines dritten Kreises (E) beschreibt und wobei der dritte Kreis (E) den ersten Kreis (A) umgibt, **dadurch gekennzeichnet, dass** die innenliegende Magnetreihe einen zweiten Kreisbogen (76) eines zweiten Kreises (C) bildet, wobei der zweite Kreisbogen (76) innerhalb des ersten Kreises (A) liegt und dass die außenliegende Magnetreihe einen vierten Kreisbogen (80) eines vierten Kreises (F) bildet, wobei der vierte Kreisbogen (80) innerhalb des dritten Kreises (E) liegt.

2. Magnetsystem nach Anspruch 1, weiter **dadurch gekennzeichnet, dass** die ersten und dritten Kreise (A, E) einen gemeinsamen Mittelpunkt (B) aufweisen.

3. Magnetsystem nach Anspruch 1 oder 2, weiter **dadurch gekennzeichnet, dass** der erste Kreisbogen (75) einen Winkel zwischen 220° und 250°, und vorzugsweise von ungefähr 235° beschreibt.

4. Magnetsystem nach einem der vorhergehenden Ansprüche, weiter **dadurch gekennzeichnet, dass** der zweite Kreisbogen (76) einen Winkel zwischen 90° und 120°, und vorzugsweise von ungefähr 103° beschreibt.

5. Magnetsystem nach einem der vorhergehenden Ansprüche, weiter **dadurch gekennzeichnet, dass** die ersten und zweiten Kreise (A, C) der innenliegenden Magnetreihe im Wesentlichen den gleichen Radius aufweisen.

6. Magnetsystem nach einem der vorhergehenden Ansprüche, weiter **dadurch gekennzeichnet, dass** der dritte Kreisbogen (78) einen Winkel zwischen 225° und 255°, und vorzugsweise von ungefähr 239° beschreibt.

7. Magnetsystem nach einem der vorhergehenden Ansprüche, weiter **dadurch gekennzeichnet, dass** der vierte Kreisbogen (80) einen Winkel zwischen 95° und 125°, und vorzugsweise von ungefähr 111° beschreibt.

8. Magnetsystem nach einem der vorhergehenden Ansprüche, weiter **dadurch gekennzeichnet, dass** der Radius des dritten Kreises (E) größer ist als der Radius des vierten Kreises (F).

9. Magnetsystem nach Anspruch 8, weiter **dadurch gekennzeichnet, dass**der Radius des dritten Kreises (E) um 80% bis 100%, vorzugsweise um ungefähr 90% größer ist als der Radius des vierten Kreises (F).

10. Magnetsystem nach einem der vorhergehenden Ansprüche, weiter **dadurch gekennzeichnet, dass** die außenliegende Magnetreihe zwei gerade Segmente (79) aufweist, die die freien Enden der dritten und vierten Kreisbögen (78, 80) verbinden.

11. Magnetsystem nach einem der vorhergehenden Ansprüche, weiter **gekennzeichnet durch** eine dritte Gruppe (72) von Magneten, die auf der Jochplatte (50) angeordnet ist, eine dem vierten Kreisbogen (80) gegenüberliegende nicht geschlossene Magnetreihe bildet und außerhalb der ersten und zweiten geschlossenen Magnetreihen liegt.

12. Magnetsystem nach Anspruch 11, weiter **dadurch gekennzeichnet, dass** die dritte Gruppe (72) von Magneten in der gleichen Richtung gepolt ist, wie die zweite Gruppe (71) von Magneten.

13. Magnetsystem nach Anspruch 11 oder 12, weiter **dadurch gekennzeichnet, dass** die dritte Gruppe (72) von Magneten einen fünften Kreisbogen (81) eines fünften Kreises (H) mit einem Winkel von 15° bis 45° und insbesondere von ungefähr 32° beschreibt.

14. Magnetsystem nach Anspruch 13, weiter **dadurch gekennzeichnet, dass** der fünfte Kreis (H) einen größeren Radius besitzt als der dritte Kreis (E).

15. Magnetsystem nach einem der Ansprüche 11 bis 14, weiter **dadurch gekennzeichnet, dass** die dritte Gruppe (72) von Magneten innerhalb des vierten Kreises (F) liegt.

16. Magnetsystem nach einem der vorhergehenden Ansprüche, weiter **dadurch gekennzeichnet, dass** die Mittelpunkte der Kreise auf einer gemeinsamen Geraden liegen.

17. Magnetsystem nach einem der vorhergehenden Ansprüche, weiter **dadurch gekennzeichnet, dass** die Magnetreihen zu der Geraden spiegelsymmetrisch sind.

18. Magnetsystem nach einem der vorhergehenden Ansprüche, weiter **dadurch gekennzeichnet, dass** die Jochplatte (50) eben ist, und um einen Mittelpunkt (X) rotationssymmetrisch ist.

19. Magnetsystem nach einem der vorhergehenden Ansprüche, weiter **dadurch gekennzeichnet, dass** ein Mittelpunkt (X) der Jochplatte und die Mittelpunkte (B, D, G) der Kreise (A, C, E, F, H) auf einer gemeinsamen Geraden (Y) liegen.

20. Magnetsystem nach Anspruch 19, weiter **dadurch gekennzeichnet, dass** der gemeinsame Mittelpunkt (B) des ersten und dritten Kreises (A, E) entlang der Geraden (Y) zum Mittelpunkt (X) der Jochplatte versetzt ist.

21. Magnetsystem nach Anspruch 20, weiter **dadurch gekennzeichnet, dass** die Mittelpunkte (D, G) des zweiten und vierten Kreises (C, F) entlang der Geraden (Y) zum Mittelpunkt der Jochplatte versetzt sind und bezüglich des Mittelpunkts (X) der Jochplatte auf einer anderen Seite liegen, wie der gemeinsame Mittelpunkt (B) des ersten und dritten Kreises (A, E).

22. Magnetsystem nach Anspruch 21, weiter **dadurch gekennzeichnet, dass** der gemeinsame Mittelpunkt (B) des ersten und dritten Kreises (A, E) mit einem Abstand zum Mittelpunkt (X) der Jochplatte angeordnet ist, der kleiner ist als ein Abstand zwischen dem Mittelpunkt (X) der Jochplatte und dem Mittelpunkt (D) des zweiten Kreises (C), und dass der Mittelpunkt (G) des vierten Kreises (F) mit einem größeren Abstand zum Mittelpunkt (X) der Jochplatte (50) angeordnet ist, als der Mittelpunkt (D) des Kreises (C).

23. Magnetsystem nach einem der vorhergehenden Ansprüche, weiter **dadurch gekennzeichnet, dass** die Magnete (54) durch wenigstens eine nichtmagnetische Platte (52) mit entsprechenden Durchführöffnungen für die Magnete (54) geführt sind.

24. Magnetsystem nach einem der vorhergehenden Ansprüche, weiter **gekennzeichnet durch** unmagnetische Ausgleichsgewichte (56) an der Jochplatte (50) zum Ausgleichen des Gewichts des Magnetsystems (7) derart, dass deren Schwerpunkt auf einer sich **durch** einen Mittelpunkt (X) der Jochplatte (50) erstreckenden Normalen liegt.

25. Zerstäubungskathode (1) mit einem Target (13), das eine vordere Zerstäubungsfläche (26) aufweist, einem hinter dem Target (13) liegenden Magnetsystem (7) nach einem der vorhergehenden Ansprüche und einer Vorrichtung (9) zum Drehen des Magnetsystems (7) um eine zur Jochplatte (50) senkrecht stehende Drehachse.

26. Zerstäubungskathode (1) nach Anspruch 25 weiter **gekennzeichnet durch** eine Steuervorrichtung zum Steuern der Drehgeschwindigkeit des Magnetsystems (7) in Abhängigkeit von einem Zerstäubungszustand des Targets (13).

27. Verfahren zum Beschichten eines Substrats durch einen Magnetron-Zerstäubungsprozess, bei dem ein Target, mit einer vorderen Zerstäubungsfläche zerstäubt wird, während ein hinter dem Target liegendes Magnetsystem nach einem der Ansprüche 1 bis 24 gedreht wird.

28. Verfahren nach Anspruch 27, weiter **dadurch gekennzeichnet, dass** der Zerstäubungszustand des Targets bestimmt wird und die Drehgeschwindigkeit des Magnetsystems in Abhängigkeit vom Zerstäubungszustand des Targets gesteuert wird.

## Claims

1. A magnet system (7) for a sputtering cathode (1), comprising a yoke plate (50) and at least a first group (70) and a second group (71) of magnets arranged with opposite polarization on the yoke plate (50), wherein the magnets of the first group (70) form a substantially closed inner row of magnets and the magnets of the second group (71) form a substantially closed outer row of magnets which radially surrounds the inner row of magnets, wherein the inner row of magnets forms a first arc (75) of a circle which encompasses an angle of more than 180° of a first circle (A) and the outer row of magnets forms a third arc (78) of a circle which encompasses an angle of more than 180° of a third circle (E) and wherein the third circle (E) surrounds the first circle (A), **characterized in that** the inner row of magnets forms a second arc (76) of a second circle (C), the second arc (76) lying within the first circle (A), and that the outer row of magnets forms a fourth arc (80) of a fourth circle (F), the fourth arc (80) lying within the third circle (E).

2. The magnet system according to claim 1, further **characterized in that** the first and third circles (A, E) have a common center (B).

3. The magnet system according to claim 1 or 2, further **characterized in that** the first arc (75) of a circle encompasses an angle between 220° and 250° and preferably of approximately 235°.

4. The magnet system according to any one of the preceding claims, further **characterized in that** the second arc (76) of a circle encompasses an angle between 90° and 120° and preferably of approximately 103°.

5. The magnet system according to any one of the preceding claims, further **characterized in that** the first and second circles (A, C) of the inner row of magnets have substantially the same radius.

6. The magnet system according to any one of the preceding claims, further **characterized in that** the third arc (78) of a circle encompasses an angle between 225° and 255° and preferably of approximately 239°.

7. The magnet system according to any one of the preceding claims, further **characterized in that** the fourth arc (80) of a circle encompasses an angle between 95° and 125° and preferably of approximately 111°.

8. The magnet system according to any one of the preceding claims, further **characterized in that** the radius of the third circle (E) is larger than the radius of the fourth circle (F).

9. The magnet system according to claim 8, further **characterized in that** the radius of the third circle (E) is larger by 80% to 100%, preferably by approximately 90%, than the radius of the fourth circle (F).

10. The magnet system according to any one of the preceding claims, further **characterized in that** the outer row of magnets has two straight segments (79) connecting the free ends of the third and fourth arcs (78, 80) of a circle.

11. The magnet system according to any one of the preceding claims, further **characterized by** a third group (72) of magnets which is arranged on the yoke plate (50), forms a non-closed row of magnets opposite to the fourth arc (80) of a circle, and lies outside the first and second closed rows of magnets.

12. The magnet system according to claim 11, further **characterized in that** the third group (72) of magnets is poled in the same direction as the second group (71) of magnets.

13. The magnet system according to claim 11 or 12, further **characterized in that** the third group (72) of magnets encompasses a fifth arc (81) of a fifth circle (H) having an angle of 15° to 45° and particularly of approximately 32°.

14. The magnet system according to claim 13, further **characterized in that** the fifth circle (H) has a larger radius than the third circle (E).

15. The magnet system according to any one of claims 11 to 14, further **characterized in that** the third group (72) of magnets lies within the fourth circle (F).

16. The magnet system according to any one of the preceding claims, further **characterized in that** the centers of the circles lie on a common straight line.

17. The magnet system according to any one of the preceding claims, further **characterized in that** the rows of magnets are mirror-symmetrical with respect to the straight line.

18. The magnet system according to any one of the preceding claims, further **characterized in that** the yoke plate (50) is plane and rotationally symmetrical with respect to a center (X).

19. The magnet system according to any one of the preceding claims, further **characterized in that** a center (X) of the yoke plate and the centers (B, D, G) of the circles (A, C, E, F, H) lie on a common straight line (Y).

20. The magnet system according to claim 19, further **characterized in that** the common center (B) of the first and third circles (A, E) is displaced along the straight line (Y) relative to the center (X) of the yoke plate.

21. The magnet system according to claim 20, further **characterized in that** the centers (D, G) of the second and fourth circles (C, F) are displaced along the straight line (Y) relative to the center of the yoke plate and, with respect to the center (X) of the yoke plate, lie on a side different from that of the common center (B) of the first and third circles (A, E).

22. The magnet system according to claim 21, further **characterized in that** the common center (B) of the first and third circles (A, E) is arranged at a distance from the center (X) of the yoke plate, said distance being smaller than a distance between the center (X) of the yoke plate and the center (D) of the second circle (C), and that the center (G) of the fourth circle (F) has a larger distance from the center (X) of the yoke plate (50) than the center (D) of the circle (C).

23. The magnet system according to any one of the preceding claims, further **characterized in that** the magnets (54) are passed through at least one non-magnetic plate (52) having corresponding openings for the magnets (54).

24. The magnet system according to any one of the preceding claims, further **characterized by** non-magnetic counterweights (56) at the yoke plate (50) for balancing the weight of the magnet system (7) such that its center of gravity lies on a normal extending through a center (X) of the yoke plate (50).

25. A sputtering cathode (1) comprising a target (13) having a front sputtering surface (26), a magnet system (7) according to any one of the preceding claims and lying downstream of the target (13), and a device (9) for rotating the magnet system (7) around a rotational axis extending perpendicular with respect to a yoke plate (50).

26. The sputtering cathode (1) according to claim 25, further **characterized by** a control device for controlling the rotational speed of the magnet system (7) depending on a sputtering state of the target (13).

27. A method for coating a substrate in a magnetron sputtering process in which a target having a front sputtering surface is sputtered while a magnet system according to any one of claims 1 to 24 and lying downstream of the target is rotated.

28. The method according to claim 27, further **characterized in that** the sputtering state of the target is determined and the rotational speed of the magnet system is controlled depending on the sputtering state of the target.

## Revendications

1. Système d'aimants (7) pour une cathode de pulvérisation (1), comprenant une plaque (50) faisant office de culasse et au moins un premier groupe (70) et un deuxième groupe (71) d'aimants qui sont disposés avec des polarités opposées sur la plaque (50) faisant office de culasse, les aimants du premier groupe (70) formant une série essentiellement fermée d'aimants internes et les aimants du deuxième groupe (71) formant une série essentiellement fermée d'aimants externes, qui entoure la série d'aimants internes en direction radiale, la série d'aimants internes formant un premier arc de cercle (75) qui décrit un angle supérieur à 180° d'un premier cercle (A), et la série d'aimants externes formant un troisième arc de cercle (78) qui décrit un angle supérieur à 180° d'un troisième cercle (E), le troisième cercle (E) entourant le premier cercle (A), **caractérisé en ce que** la série d'aimants internes forme un deuxième arc de cercle (78) d'un deuxième cercle (C), le deuxième arc de cercle (76) étant situé à l'intérieur du premier cercle (A) et **en ce que** la série d'aimants externes forme un quatrième arc de cercle (80) d'un quatrième cercle (F), le quatrième arc de cercle (80) étant disposé à l'intérieur du troisième cercle (E).

2. Système d'aimants selon la revendication 1, **caractérisé en outre en ce que** le premier et le troisième cercle (A, E) présentent un centre commun (B).

3. Système d'aimants selon la revendication 1 ou 2, **caractérisé en outre en ce que** le premier arc de cercle (75) décrit un angle entre 220° et 250° et de préférence d'environ 235°.

4. Système d'aimants selon l'une quelconque des revendications précédentes, **caractérisé en outre en ce que** le deuxième arc de cercle (76) décrit un angle entre 90° et 120° et de préférence d'environ 103°.

5. Système d'aimants selon l'une quelconque des revendications précédentes, **caractérisé en outre en ce que** le premier et le deuxième cercle (A, C) de la série d'aimants internes présentent essentiellement le même rayon.

6. Système d'aimants selon l'une quelconque des revendications précédentes, **caractérisé en outre en ce que** le troisième arc de cercle (78) décrit un angle entre 225° et 255° et de préférence d'environ 239°.

7. Système d'aimants selon l'une quelconque des revendications précédentes, **caractérisé en outre en ce que** le quatrième arc de cercle (80) décrit un angle entre 95° et 125° et de préférence d'environ 111°.

8. Système d'aimants selon l'une quelconque des revendications précédentes, **caractérisé en outre en ce que** le rayon du troisième cercle (E) est supérieur au rayon de quatrième cercle (F).

9. Système d'aimants selon la revendication 8, **caractérisé en outre en ce que** le rayon du troisième cercle (E) est supérieur à concurrence de 80 % à 100 %, de préférence à concurrence d'environ 90 %, au rayon du quatrième cercle (F).

10. Système d'aimants selon l'une quelconque des revendications précédentes, **caractérisé en outre en ce que** la série d'éléments externes présente deux segments droits (79) qui relient les extrémités libres du troisième et du quatrième arc de cercle (78, 80).

11. Système d'aimants selon l'une quelconque des revendications précédentes, **caractérisé en outre par** un troisième groupe (72) d'aimants qui est disposé sur la plaque (50) faisant office de culasse, qui forme une série non fermée d'aimants opposée au quatrième arc de cercle (80) et qui est disposé à l'extérieur de la première et de la deuxième série fermée d'aimants.

12. Système d'aimants selon la revendication 11, **caractérisé en outre en ce que** le troisième groupe d'aimants (72) est polarisé dans la même direction que celle du deuxième groupe d'aimants (71).

13. Système d'aimants selon la revendication 11 ou 12, **caractérisé en outre en ce que** le troisième groupe d'aimants (72) forme un cinquième arc de cercle (81) d'un cinquième cercle (H) qui décrit un angle de 15° à 45° et en particulier d'environ 32°.

14. Système d'aimants selon la revendication 13, **caractérisé en outre en ce que** le cinquième cercle (H) possède un rayon supérieur à celui du troisième cercle (E).

15. Système d'aimants selon l'une quelconque des revendications 11 à 14, **caractérisé en outre en ce que** le troisième groupe d'aimants (72) est situé à l'intérieur du quatrième cercle (F).

16. Système d'aimants selon l'une quelconque des revendications précédentes, **caractérisé en outre en ce que** les centres des cercles sont situés sur une droite commune.

17. Système d'aimants selon l'une quelconque des revendications précédentes, **caractérisé en outre en ce que** les séries d'aimants sont disposées en symétrie spéculaire par rapport à la droite.

18. Système d'aimants selon l'une quelconque des revendications précédentes, **caractérisé en outre en ce que** la plaque (50) faisant office de culasse est plane et présente une symétrie de rotation autour d'un centre (X).

19. Système d'aimants selon l'une quelconque des revendications précédentes, **caractérisé en outre en ce qu'**un centre (X) de la plaque faisant office de culasse et les centres (B, D, G) des cercles (A, C, E, F, H) sont situés sur une droite commune (Y).

20. Système d'aimants selon la revendication 19, **caractérisé en outre en ce que** le centre commun (B) du premier et du troisième cercle (A, E) est décalé, le long de la droite (Y), par rapport au centre (X) de la plaque faisant office de culasse.

21. Système d'aimants selon la revendication 20, **caractérisé en outre en ce que** les centres (D, G) du deuxième et du quatrième cercle (C, F) sont décalés, le long de la droite (Y) par rapport au centre de la plaque faisant office de culasse et sont disposés, par rapport au centre (X) de la plaque faisant office de culasse, sur autre côté, au même titre que le centre commun (B) du premier et du troisième cercle (A, E).

22. Système d'aimants selon la revendication 21, **caractérisé en outre en ce que** le centre commun (B) du premier et du troisième cercle (A, E) est disposé à une distance du centre (X) de la plaque faisant office de culasse, qui est inférieure à la distance s'étendant entre le centre (X) de la plaque faisant office de culasse et le centre (D) du deuxième cercle (C), et **en ce que** le centre (G) du quatrième cercle (F) est disposé à une distance du centre (X) de la plaque (50) faisant office de culasse, supérieure à la distance par rapport au centre (D) du cercle (C).

23. Système d'aimants selon l'une quelconque des revendications précédentes, **caractérisé en outre en ce que** les aimants (54) sont guidés via au moins une plaque amagnétique (52) comprenant des ouvertures de passage correspondantes pour les aimants (54).

24. Système d'aimants selon l'une quelconque des revendications précédentes, **caractérisé en outre par** des contrepoids amagnétiques (56) sur la plaque (50) faisant office de culasse pour équilibrer le poids du système d'aimants (7) de telle sorte que leur centre de gravité est situé sur une perpendiculaire passant par le centre (X) de la plaque (50) faisant office de culasse.

25. Cathode de pulvérisation (1) comprenant une cible (13) qui présente une surface antérieure de pulvérisation (26), un système d'aimants (7) disposé derrière la cible (13), selon l'une quelconque des revendications précédentes et un dispositif (9) pour entraîner en rotation le système d'aimants (7) autour d'un axe de rotation perpendiculaire à la plaque (50) faisant office de culasse.

26. Cathode de pulvérisation (1) selon la revendication 25, **caractérisé en outre par** un dispositif de réglage pour le réglage de la vitesse de rotation du système d'aimants (7) en fonction d'un état de pulvérisation de la cible (13).

27. Procédé pour l'enduction d'un substrat via un processus de pulvérisation faisant appel à un magnétron, dans lequel une cible, comprenant une surface antérieure de pulvérisation, est soumise à une pulvérisation, tandis qu'un système d'aimants disposé derrière la cible, selon l'une quelconque des revendications 1 à 24, est mis en rotation.

28. Procédé selon la revendication 27, **caractérisé en outre en ce qu'**on détermine l'état de pulvérisation de la cible et on règle la vitesse de rotation du système d'aimants en fonction de l'état de pulvérisation de la cible.
